# EUROPEAN PATENT APPLICATION

(11) **EP 4 576 989 A1**
(43) Date of publication of application: **25.06.2025**
(21) Application number: 24216710.4
(22) Date of filing: 02.12.2024
(51) Int. Cl.: H10D 30/01, H10D 30/66, H10D 62/13

(54) **POWER SEMICONDUCTOR DEVICE AND POWER CONVERTER INCLUDING THE SAME**

(30) Priority: 19.12.2023 KR 20230186366; 03.07.2024 KR 20240087563
(71) Applicant: LX Semicon Co., Ltd., Daejeon 34027 (KR)
(72) Inventor: LEE, Chung Kwang, 34027 Daejeon (KR); KIM, Jin Gon, 34027 Daejeon (KR)
(74) Representative: Goddar, Heinz J.

(57) **Abstract**

A power semiconductor device according to an embodiment may include a substrate, an epi layer of a first conductivity type disposed on the substrate, a plurality of wells of a second conductivity type arranged spaced apart from each other on the epi layer of the first conductivity type; a gate disposed between the plurality of wells of the second conductivity type, a gate insulating layer disposed to surround at least a portion of the gate; and a doped region of the first conductivity type disposed on a side of the gate insulating layer. The doped region of the first conductivity type may include a first doped region of the first conductivity type and a second doped region of the first conductivity type disposed below the first doped region of the first conductivity type. And a doping concentration of the second doped region of the first conductivity type may be lower than a doping concentration of the first doped region of the first conductivity type.

## Description

### BACKGROUND OF THE DISCLOSURE

### 1. Field of the Disclosure

The embodiment relates to a power semiconductor device and a power converter including the same.

### 2. Background of the Related Art

Power semiconductor is one of the key elements that determines the efficiency, speed, durability, and reliability of power electronic systems.

With the recent development of the power electronics industry, the previously used silicon (Si) power semiconductors have reached their physical limits, research is being actively conducted on WBG (wide bandgap) power semiconductors such as silicon carbide (SiC) and gallium nitride (GaN) power semiconductor to replace the Si power semiconductor.

WBG power semiconductor devices have a band gap energy that is approximately three times than that of Si power semiconductor devices, due to this, it has the characteristics of low intrinsic carrier concentration, high breakdown electric field (about 4 to 20 times), high thermal conductivity (about 3 to 13 times), and large electron saturation rate (about 2 to 2.5 times) comparing the Si power semiconductor.

Since these characteristics enable operation in high temperature and high voltage environments, the WBG power semiconductor devices have high switching speed and low switching loss. Among these, gallium nitride (GaN) power semiconductor devices may be used in low-voltage systems, and silicon carbide (SiC) power semiconductor devices may be suitable for high-voltage systems.

SiC MOSFET power semiconductors in the prior art generally have a vertical diffused structure and are referred to as VDMOSFETs, and also may be referred to simply as double-diffused structure DMOSFETs. Additionally, SiC MOSFETs may be classified into Planar MOSFETs and Trench MOSFETs depending on the direction of the channel.

On the other hand, MOSFET with the trench structure has a problem in that electric field is concentrated in an edge area according to the shape of the trench gate. Even if a P-shield process is performed to solve this, there are problems such as adding a mask layer, an increased process difficulty, and an increased cell pitch, so a new solution is needed.

In addition, MOSFET with the conventional trench structure has a problem in that the reliability of the device is reduced because it is difficult to precisely control the channel area and the short circuit characteristics.

### SUMMARY OF THE DISCLOSURE

One of the technical objects of the embodiment is to prevent the electric field concentration in a lower edge area of the trench gate.

In addition, one of the technical objects of the embodiment is to improve the reliability of the device during a high-speed switching.

The technical problems of the embodiment are not limited to those described in this item and include those that can be understood through the description of the invention.

A power semiconductor device according to an embodiment and a power converter including the same may include: a substrate (110); an epi layer of a first conductivity type (117) disposed on the substrate (110); a plurality of wells of a second conductivity type (130) arranged spaced apart from each other on the epi layer of the first conductivity type (117); a gate (160) disposed between the plurality of wells of the second conductivity type (130); a gate insulating layer (155) disposed to surround at least a portion of the gate (160); and a doped region of the first conductivity type (140a) disposed on a side of the gate insulating layer (155). The doped region of the first conductivity type may include a first doped region of the first conductivity type (140a) and a second doped region of the first conductivity type (140b) disposed below the first doped region of the first conductivity type (140a). And a doping concentration of the second doped region of the first conductivity type (140b) may be lower than a doping concentration of the first doped region of the first conductivity type (140a).

In addition, in an embodiment, a bottom surface of the second doped region of the first conductivity type (140b) may be positioned higher than a bottom surface of the gate (160).

In addition, in the embodiment, a lower edge region of the gate insulating layer (155) may be in contact with the wells of the second conductivity type (130).

In addition, in the embodiment, a bottom surface of the wells of the second conductivity type (130) may be positioned lower than the bottom surface of the gate insulating layer (155).

In addition, in the embodiment, the doped region of the first conductivity type (140) and the epi layer of the first conductivity type (117) do not contact each other, and the wells of the second conductivity type (130) may be positioned between the doped region of the first conductivity type (140) and the epi layer of the first conductivity type (117).

In addition, in the embodiment, the first doped region of the first conductivity type (140a) and the second doped region of the first conductivity type (140b) may be in contact with one side surface of the gate insulating layer (155).

In addition, in the embodiment, a longitudinal direction of the first doped region of the first conductivity type (140a) may be horizontal, and a longitudinal direction of the second doped region of the first conductivity type (140b) may be vertical.

In addition, in the embodiment, a horizontal width of the second doped region of the first conductivity type (140b) may be less than a horizontal width of the first doped region of the first conductivity type (140a).

In addition, in the embodiment, a depth of the doped region of the first conductivity type (140) may be less than a depth of the gate (160).

In addition, in the embodiment, the second doped region of the first conductivity type (140b) may not vertically overlap with the source contact layer (145).

In addition, in the embodiment, a JFET region (150) disposed on a bottom surface of the gate insulating layer (155) is further included, and the JFET region (150) can be in contact with the plurality of wells of the second conductivity type (130).

A horizontal width of the JFET region can be larger than a horizontal width of the gate.

A first length (L1) of the second doped region of the first conductivity type (140b) in contact with the gate insulating layer (155) can be longer than a second length (L2) of the wells of the second conductivity type (130) in contact with the gate insulating layer (155).

A region of the wells of the second conductivity type (130) in contact with the gate insulating layer can be disposed below the second doped region of the first conductivity type (140b).

In addition, the power semiconductor device according to the embodiment may include a substrate, an epi layer of a first conductivity type (117) disposed on the substrate, a plurality of wells of a second conductivity type (130) spaced apart from each other on the epi layer of the first conductivity type (117), a gate disposed between the plurality of wells of the second conductivity type (130), and a gate insulating layer (155) disposed to surround at least a portion of the gate.

In addition, the embodiment includes a doped region of the first conductivity type (140) disposed on a side of the gate insulating layer (155).

The doped region of the first conductivity type (140) may include a first doped region of the first conductivity type (140a) and a second doped region of the first conductivity type (140b) disposed below the first doped region of the first conductivity type (140a).

A doping concentration of the second doped region of the first conductivity type (140b) may be lower than a doping concentration of the first doped region of the first conductivity type (140a).

An upper surface of the second doped region of the first conductivity type may be in contact with a bottom surface of the first doped region of the first conductivity type.

An inner surface of the second doped region of the first conductivity type may be aligned with an inner surface of the first doped region of the first conductivity type between the upper and bottom surfaces.

A vertical thickness of the second doped region of the first conductivity type may be greater than 1/2 of the vertical thickness of the gate.

In addition, the power semiconductor device according to the embodiment may include a substrate, an epi layer of a first conductivity type disposed on the substrate, a plurality of wells of a second conductivity type spaced apart from each other on the epi layer of the first conductivity type, a gate disposed between the plurality of wells of the second conductivity type, and a gate insulating layer disposed to surround at least a portion of the gate.

In addition, the embodiment may include a doped region of the first conductivity type disposed on a side of the gate insulating layer, and the doped region of the first conductivity type may include a first doped region of the first conductivity type and a second doped region of the first conductivity type disposed below the first doped region of the first conductivity type.

A horizontal width of the second doped region of the first conductivity type may be less than a horizontal width of the first doped region of the first conductivity type.

A doping concentration of the second doped region of the first conductivity type may be lower than a doping concentration of the first doped region of the first conductivity type.

A bottom surface of the second doped region of the first conductivity type is positioned higher than a bottom surface of the gate, and a lower edge area of the gate insulating layer can be in contact with the wells of the second conductivity type.

A bottom surface of the wells of the second conductivity type may be positioned lower than a bottom surface of the gate insulating layer, the doped region of the first conductivity type and the epi layer of the first conductivity type are spaced apart from each other, and the wells of the second conductivity type can be positioned between the doped region of the first conductivity type and the epi layer of the first conductivity type.

An inner surface of the second doped region of the first conductivity type is aligned vertically with an inner surface of the first doped region of the first conductivity type, and a vertical thickness of the second doped region of the first conductivity type can be greater than 1/2 of a vertical thickness of the gate.

### EFFECTS OF THE DISCLOSURE

The power semiconductor device according to the embodiment has a technical effect of preventing the electric field concentration in the lower edge region of the trench gate.

For example, the embodiment can prevent the electric field concentration in the lower edge region of the trench gate by arranging the wells of the second conductivity type to surround the lower edge region of the trench gate.

In addition, the embodiment can prevent the electric field concentration in the lower edge region of the trench gate without a separate P-shield process, so that a high-energy ion implantation process is not required, thereby preventing damage to the device and simplifying the process.

In addition, the embodiment has a technical effect of improving the reliability of the device during high-speed switching.

For example, since the doping concentration of the second doped region of the first conductivity type disposed on the trench gate side is formed lower than the doping concentration of the first doped region of the first conductivity type, the saturation current decreases and the SCWT (Short Circuit Withstand Time) increases, so that the reliability of the device can be improved during high-speed switching.

The technical effects of the embodiment are not limited to those described in this item and include those that can be understood through the description of the invention.

### BRIEF DESCRIPTION OF THE DRAWINGS

FIG. 1 is an example view of a power converter (1000) according to an embodiment.
FIG. 2 is a cross-sectional view of a power semiconductor device (100) according to an embodiment.
FIG. 3 is a cross-sectional view of a power semiconductor device according to an embodiment.
FIGS. 4A to 4F are manufacturing process views of a power semiconductor device according to an embodiment.

### DETAILED DESCRIPTION OF THE DISCLOSURE

Hereinafter, the embodiments disclosed in this specification will be described in detail with reference to the attached drawings. The suffixes 'module' and 'part' used for elements in the following description are given or used interchangeably in consideration of the ease of writing the specification, and do not have distinct meanings or roles in themselves. In addition, the attached drawings are intended to facilitate easy understanding of the embodiments disclosed in this specification, and the technical ideas disclosed in this specification are not limited by the attached drawings. In addition, when an element such as a layer, region, or substrate is mentioned as existing 'on' another element, this includes that it may be directly on the other element, or that other intermediate elements may exist in between.

In the specification or claims, the meaning of "an element A includes at least one of a, b, and/or c" may include ① when the element A includes a, ② when the element A includes b, ③ when the element A includes c, ④ when the element A includes a and b, ⑤ when the element A includes b and c, ⑥ when the element A includes a and c, and ⑦ when the element A includes all of a, b, and c.

The singular expression includes the plural expression as well as the singular expression unless the context clearly indicates otherwise. For example, the meaning of "element A includes a structure" may include the meaning of "element A includes one or more structures."

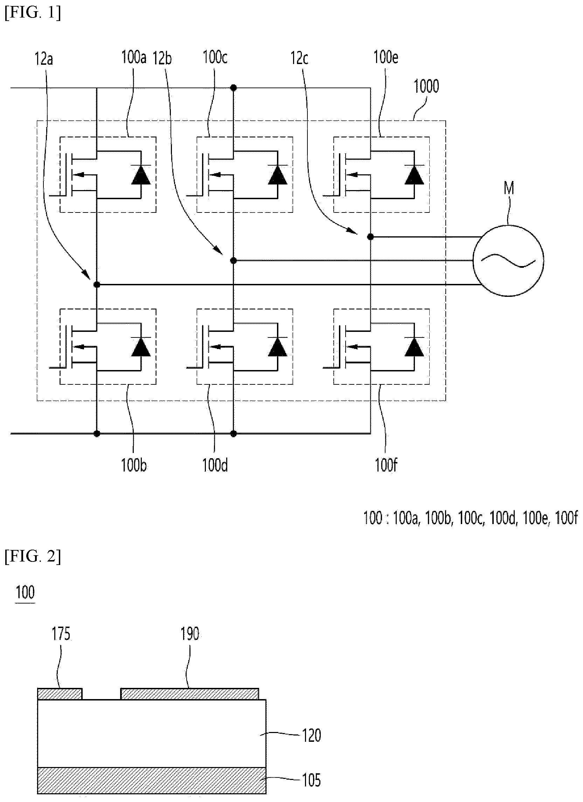

FIG. 1 is an example view of a power converter (1000) according to an embodiment.

The power converter (1000) according to the embodiment can receive DC power from a battery or a fuel cell, convert it into AC power, and supply AC power to a predetermined load. For example, the power converter (1000) according to the embodiment can include an inverter, and can receive DC power from a battery, convert it into three-phase AC power, and supply it to a motor (M), and the motor (M) can provide power to an electric vehicle, a fuel cell vehicle, etc.

The power converter (1000) according to the embodiment can include a power semiconductor device (100). The power semiconductor device (100) can be a MOSFET (Metal Oxide Semiconductor Field Effect Transistor), but is not limited thereto, and can include an IGBT (Insulated Gate Bipolar Transistor).

For example, the power converter (1000) may include a plurality of power semiconductor devices (100a, 100b, 100c, 100d, 100e, 100f) and may include a plurality of diodes (not shown). Each of the plurality of diodes may be embedded in the power semiconductor devices (100a, 100b, 100c, 100d, 100e, 100f) in the form of an internal diode, but is not limited thereto, and may be disposed separately.

The embodiment may convert DC power into AC power through on-off control for a plurality of power semiconductor devices (100a to 100f). For example, the power converter (1000) according to the embodiment can supply positive power to the motor (M) by turning on the first power semiconductor device (100a) and turning off the second power semiconductor device (100b) in the first-time section of one cycle, and supply negative power to the motor (M) by turning off the first power semiconductor device (100a) and turning on the second power semiconductor device (100b) in the second time section of one cycle.

In the embodiment, a group of power semiconductor devices arranged in series in the high-voltage line and the low-voltage line of the input side can be called an arm. For example, the first power semiconductor device (100a) and the second power semiconductor device (100b) can be called a first arm. The third power semiconductor device (100c) and the fourth power semiconductor device (100d) may constitute a second arm, and the fifth power semiconductor device (100e) and the sixth power semiconductor device (100f) may constitute a third arm.

In the arm, the upper power semiconductor device and the lower power semiconductor device may be controlled not to be turned on at the same time. For example, in the first arm, the first power semiconductor device (100a) and the second power semiconductor device (100b) may not be turned on at the same time but may be turned on and off alternately.

Each power semiconductor device (100a to 100f) may be supplied with a high voltage in an off state. For example, when the first power semiconductor device (100a) is turned on and the second power semiconductor device (100b) is turned off, the input voltage can be applied as is to the second power semiconductor device (100b). The voltage input to the second power semiconductor device (100b) can be a relatively high voltage, and the withstand voltage of each power semiconductor device (100a to 100f) can be designed to be at a high level to withstand this high voltage.

Each power semiconductor device (100a to 100f) can conduct a high current when turned on. The motor (M) is driven by a relatively high current, and this high current can be supplied to the motor (M) through the power semiconductor device that is turned on.

The high voltage applied to each power semiconductor device (100a to 100f) can cause a high switching loss. High currents that conduct power semiconductor devices (100a to 100f) can cause high conduction losses. In order to dissipate heat generated by such losses, power semiconductor devices (100a to 100f) can be packaged into a power semiconductor module including a heat dissipation means.

The power semiconductor device (100) of the embodiment can be a silicon carbide (SiC) power semiconductor device, and can operate in a high temperature, high voltage environment and have a high switching speed and low switching loss.

Meanwhile, the power converter (1000) according to the embodiment can include a plurality of power semiconductor modules.

For example, a plurality of power semiconductor devices (100a to 100f) illustrated in FIG. 1 can be packaged into one power semiconductor module, or the power semiconductor devices constituting each arm can be packaged into one power semiconductor module.

For example, the first power semiconductor device (100a), the second power semiconductor device (100b), the third power semiconductor device (100c), the fourth power semiconductor device (100d), the fifth power semiconductor device (100e), and the sixth power semiconductor device (100f) illustrated in FIG. 1 may be packaged as one power semiconductor module.

In addition, in order to increase the current capacity, there may be additional power semiconductor devices arranged in parallel with each power semiconductor device (100a to 100f). In this case, the number of power semiconductor devices included in the power semiconductor module may be more than six.

The power converter (1000) according to the embodiment may also include a diode-type power semiconductor device in addition to the transistor-type power semiconductor devices (100a to 100f). For example, a first diode (not shown) may be disposed in parallel with the first power semiconductor device (100a), and a second diode (not shown) may be disposed in parallel with the second power semiconductor device (100b). In addition, these diodes may also be packaged together in one power semiconductor module. In addition, the diodes may be disposed in the form of internal diodes in each power semiconductor device.

Next, the power semiconductor devices constituting each arm may be packaged in one power semiconductor module.

For example, the first power semiconductor device (100a) and the second power semiconductor device (100b) constituting the first arm may be packaged as a first power semiconductor module, the third power semiconductor device (100c) and the fourth power semiconductor device (100d) constituting the second arm may be packaged as a second power semiconductor module, and the fifth power semiconductor device (100e) and the sixth power semiconductor device (100f) constituting the third arm may be packaged as a third power semiconductor module.

In addition, in order to increase the current capacity, there may be additional power semiconductor devices arranged in parallel with each power semiconductor device (100a to 100f), and in this case, the number of power semiconductor devices included in each power semiconductor module may be more than two. And, in addition to the transistor-type power semiconductor devices (100a to 100f), each arm may also include a diode-type power semiconductor device (not shown), and these diodes may also be packaged together in one power semiconductor module. In addition, the diode may be disposed in the form of an internal diode in each power semiconductor device.

Next, FIG. 2 is a cross-sectional view of one of the power semiconductor devices (100) according to the embodiment.

The power semiconductor device (100) according to the embodiment may include a source electrode (190), a gate electrode (175) disposed on an upper side of a predetermined semiconductor epi layer (120), and a drain electrode (105) disposed on a lower side of the semiconductor epi layer (120).

In the form of a MOSFET, the source electrode (190) or the gate electrode (175) may include an Al or Al alloy, and the drain electrode (105) may include a Ti/Ni/Ag metal including a Ti layer, a Ni layer, and an Ag layer, or NiV/Ag, V(vanadium)/Ni/Ag, etc., but is not limited thereto.

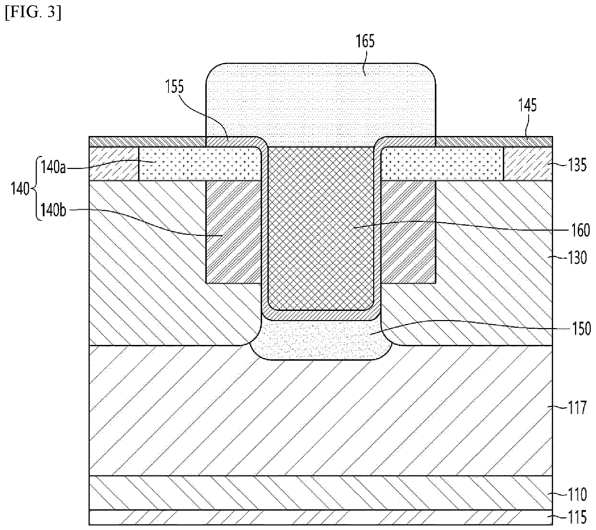

Next, FIG. 3 is a cross-sectional view of a power semiconductor device according to an embodiment. Referring to FIG. 3, the power semiconductor device according to an embodiment may include at least one of a substrate (110), a drain electrode (115), an epi layer of a first conductivity type (117), a plurality of wells of a second conductivity type (130), a doped region of the first conductivity type (140), a source contact layer (145), a gate (160), and a gate insulating layer (155). `epi layer of the first conductivity type' may be referred to as an `epi layer', and `wells of the second conductivity type' may be referred to as 'wells'. Also, the expressions of `first conductivity type' or 'second conductivity type' may be omitted for other elements.

In detail, in the embodiment, a drain electrode (115) may be disposed under the substrate (110). Also, the epi layer of the first conductivity type (117) may be disposed on the substrate (110). The epi layer of the first conductivity type (117) may be an N-type drift region, but is not limited thereto.

Also, the wells of the second conductivity type (130) may be disposed on the epi layer of the first conductivity type (117). The wells of the second conductivity type (130) may include a plurality of wells arranged spaced apart from each other. Between the above-mentioned plurality of wells of the second conductivity type (130), a gate (160) and a gate insulating layer (155) may be disposed. The gate insulating layer (155) may be disposed to surround side and bottom surfaces of the gate (160). The gate (160) may be located on an inner side of the gate insulating layer (155). In addition, a JFET region (150) may be disposed below the gate (160) and the gate insulating layer (155) to protect the gate insulating layer (155), but is not limited thereto.

Meanwhile, in the case of the trench MOSFET studied internally, a problem has been studied in which the gate insulating layer may be damaged due to an electric field being concentrated in a lower edge region of the trench gate. To this end, a separate ion implantation region such as a P-shield process was formed to prevent the electric field concentration, but there was difficulty in the process of forming a separate ion implantation region.

In addition, the trench-structured MOSFET had a problem in that the reliability of the device was reduced because it was difficult to precisely control a channel area and short circuit characteristics.

To solve the above problem, in the embodiment, the wells of the second conductivity type (130) may be formed deeper than the gate (160) and the gate insulating layer (155). In detail, a bottom surface of the wells of the second conductivity type (130) may be positioned lower than bottom surfaces of the gate (160) and the gate insulating layer (155). In addition, the wells of the second conductivity type (130) may be in contact with the gate insulating layer (155). Therefore, the embodiment has a technical effect in that the wells of the second conductivity type (130) are arranged to surround a lower edge area of the trench gate, thereby preventing electric field concentration.

In addition, in the embodiment, a doped region of the first conductivity type (140), an ion implantation region of the second conductivity type (135), and a source contact layer (145) may be disposed on the wells of the second conductivity type (130). The doped region of the first conductivity type (140) may be disposed on a side of the gate insulating layer (155). The doped region of the first conductivity type (140) may be disposed to extend along the gate insulating layer (155) to the source contact layer (145). The source contact layer (145) may be electrically connected to a source electrode (not shown).

Meanwhile, the doped region of the first conductivity type (140) may include a first doped region of the first conductivity type (140a) and a second doped region of the first conductivity type (140b) disposed below the first doped region of the first conductivity type (140a). The first doped region of the first conductivity type (140a) may be in contact with the source contact layer (145). In addition, the first doped region of the first conductivity type (140a) may be in contact with the ion implantation region of the second conductivity type (135).

In addition, the first doped region of the first conductivity type (140a) may be in contact with the gate insulating layer (155). A top surface of the first doped region of the first conductivity type (140a) may correspond to a top surface of the gate (160). A longitudinal direction of the first doped region of the first conductivity type (140a) may be a horizontal direction. In addition, a longitudinal direction of the second doped region of the first conductivity type (140b) may be vertical.

In addition, the second doped region of the first conductivity type (140b) may be in contact with a side surface of the gate insulating layer (155). The second doped region of the first conductivity type (140b) may be disposed to extend vertically from a bottom surface of the first doped region of the first conductivity type (140a). In addition, a bottom surface of the second doped region of the first conductivity type (140b) may be positioned higher than a bottom surface of the gate (160). In addition, a horizontal width of the second doped region of the first conductivity type (140b) may be less than a horizontal width of the second doped region of the first conductivity type (140b). In addition, one side surface of the second doped region of the first conductivity type (140b) may have a width corresponding to one side surface of the insulating layer (165) covering the gate (160).

Meanwhile, a doping concentration of the second doped region of the first conductivity type (140b) may be lower than a doping concentration of the first doped region of the first conductivity type (140a). The doping concentration of the doped region (140) that contacts a side surface of the gate insulating layer (155) may vary in a vertical direction.

Meanwhile, in the embodiment, current may flow through the drain electrode (115), the substrate (110), the epi layer of the first conductivity type (117), the wells of the second conductivity type (130), the second doped region of the first conductivity type (140b), the first doped region of the first conductivity type (140a), and the source electrode (not shown). In addition, a channel may be formed between the bottom surface of the second doped region of the first conductivity type (140b) and the bottom surface of the wells of the second conductivity type (130).

Therefore, in the embodiment, as the current passes through the doped region of the first conductivity type (140) in which the doping concentration changes in the vertical direction from the trench gate side, the saturation current can be reduced. In detail, by controlling a sheet resistance in the second doped region of the first conductivity type (140b) which is doped less than the first doped region of the first conductivity type (140a) to relatively increase, the on-resistance (Ron) in the second doped region of the first conductivity type (140b) can be relatively increased, thereby reducing the saturation current. Therefore, the embodiment has a technical effect of improving reliability during high-speed switching by increasing the SCWT (Short Circuit Withstand Time) as the saturation current decreases.

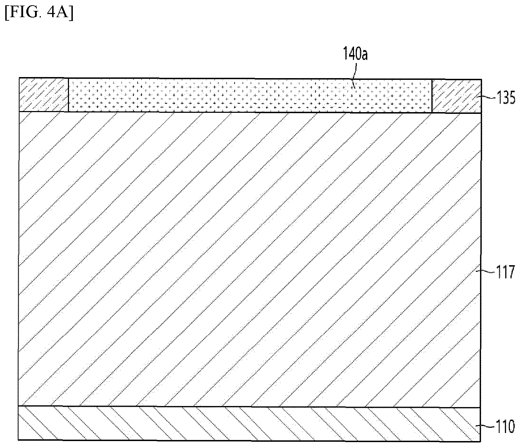

Hereinafter, the technical features of the embodiment will be described in detail while explaining the manufacturing process of the power semiconductor device according to the embodiment with reference to FIGS. 4A to 4F.

Referring to FIG. 4A, the epi layer of the first conductivity type (117) can be formed on the substrate (110).

The substrate (110) and the epi layer of the first conductivity type (117) may include SiC (Silicon Carbide), but are not limited thereto.

For example, the substrate (110) and the epi layer of the first conductivity type (117) may include 4H-SiC material, but are not limited thereto. For example, the substrate (110) and the epi layer of the first conductivity type (117) may include 3C-SiC or 6H-SiC.

In addition, the epi layer of the first conductivity type (117) may include multiple layers having different concentrations and may have a current spreading layer (CSL) function.

For example, the epi layer of the first conductivity type (117) may include a first conductivity type buffer layer (not shown) and a first conductivity type drift layer (not shown).

In addition, the first conductivity type may be N type, and the second conductivity type may be P type, but is not limited thereto.

In addition, the first doped region of the first conductivity type (140a) and the ion implantation region of the second conductivity type (135) of the second conductivity type may be formed on the epi layer of the first conductivity type (117) through an implant process. The first doped region of the first conductivity type (140a) may be disposed between the ion implantation region of the second conductivity type (135). The longitudinal direction or the length direction of the first doped region of the first conductivity type (140a) may be a horizontal direction.

For example, the first doped region of the first conductivity type (140a) can function as a source region of the first conductivity type, and can be formed by ion implanting an N-type dopant such as nitrogen or phosphorus at a concentration of about 1×10¹⁹cm⁻³ to about 3×10²⁰cm⁻³.

In addition, the ion implantation region of the second conductivity type (135) can be contacted with a source electrode thereafter. In addition, the ion implantation region of the second conductivity type (135) can function to maintain the potential of the wells of the second conductivity type (130) of the second conductivity type, and can function as a body diode.

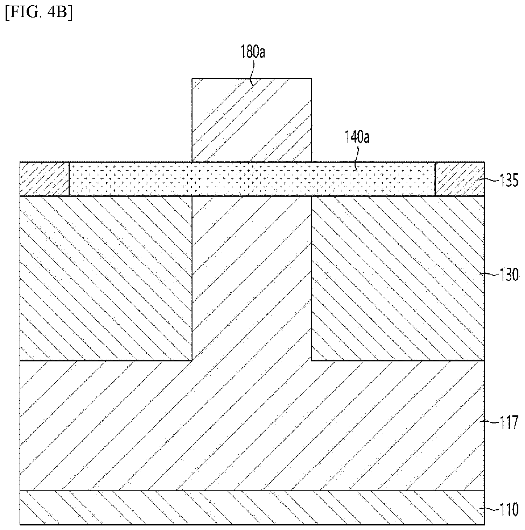

Next, referring to FIG. 4B, after a first mask (180a) is placed on the first doped region of the first conductivity type (140a), the wells of the second conductivity type (130) can be formed through an implant process. The wells of the second conductivity type (130) can be ion-implanted with a P-type dopant at a concentration of about 1×10¹⁶ cm⁻³ to about 2×10¹⁹ cm⁻³. For example, aluminum or boron can be implanted, but is not limited thereto. The wells of the second conductivity type (130) can include a plurality of regions spaced apart from each other by a first mask (180a) with an epi layer of the first conductivity type (117) interposed therebetween.

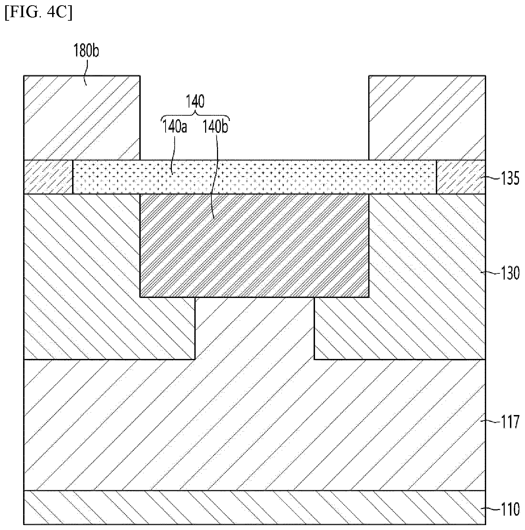

Next, referring to FIG. 4C, after a second mask (180b) may be placed on a portion of the first doped region of the first conductivity type (140a), the second doped region of the first conductivity type (140b) can be formed under the first doped region of the first conductivity type (140a) through an implant process. The horizontal width of the second doped region of the first conductivity type (140b) can be formed less than the horizontal width of the first doped region of the first conductivity type (140a). In addition, the depth of the second doped region of the first conductivity type (140b) may be shallower than the depth of the wells of the second conductivity type (130).

For example, the depth of the second doped region of the first conductivity type (140b) may be 50% to 80% of the depth of the wells of the second conductivity type (130), but is not limited thereto.

The wells of the second conductivity type (130) region exposed in the subsequent trench etching process may be a channel region.

In addition, the doping concentration of the second doped region of the first conductivity type (140b) may be lower than the doping concentration of the first doped region of the first conductivity type (140a).

For example, the second doped region of the first conductivity type (140b) may be formed by ion implanting an N-type dopant, such as nitrogen or phosphorus, at a concentration of about 1×10¹⁷ cm⁻³ to about 3×10¹⁹ cm³, but is not limited thereto.

According to the embodiment, the doping concentration of the second doping region (140b) is controlled to be lower than the doping concentration of the first doping region (140a), and through this, the on-resistance (Ron) in the second doping region (140b) is relatively increased. And since the saturation current is reduced, the SCWT (Short Circuit Withstand Time) can be increased, there is technical effect in that the reliability can be improved during high-speed switching.

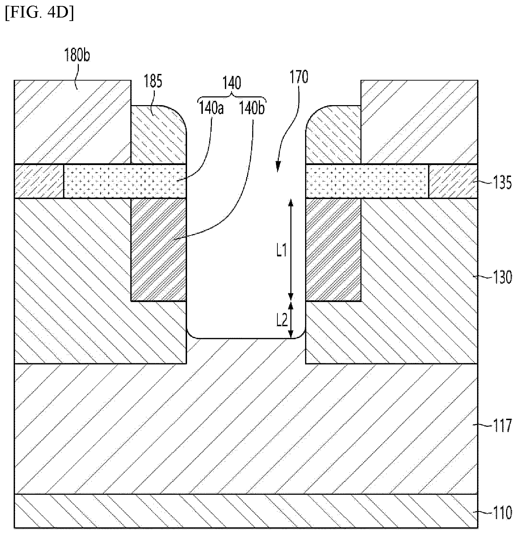

Next, referring to FIG. 4D, a spacer (185) formed as an insulating layer or the like can be placed on the side of the second mask (180b). The spacer (185) can be placed so that the side of the spacer (185) corresponds to one side of the wells of the second conductivity type (130). For example, the spacer (185) can be an inverted form of the first mask (180a) used previously.

Afterwards, a portion of the first doped region of the first conductivity type (140a), the second doped region of the first conductivity type (140b), and the epi layer of the first conductivity type (117) may be etched to form a trench (170). The bottom surface of the trench (170) may be positioned higher than the bottom surface of the wells of the second conductivity type (130), but is not limited thereto.

In the embodiment, the first length (L1) of the second doped region of the first conductivity type (140b) exposed by the trench (170) may be longer than the second length (L2) of the wells of the second conductivity type (130) exposed by the trench (170). For example, the second length (L2) of the wells of the second conductivity type (130) exposed by the trench (170) may be about 40% to 70% of the total depth of the trench (170), but is not limited thereto.

The second length (L2) region of the wells of the second conductivity type (130) exposed by the trench (170) can function as a channel region.

According to the embodiment, a channel region can be formed, and the wells of the second conductivity type (130) is arranged to surround the lower edge region of the trench gate, so that electric field concentration can be prevented in the lower edge region of the trench gate.

Accordingly, the embodiment can form the wells of the second conductivity type (130) to surround the lower edge region of the trench gate without a separate P-Shield process, and thus, there is a technical effect of preventing damage to the device and improving the reliability of the device by eliminating the need for a high-energy ion implantation process.

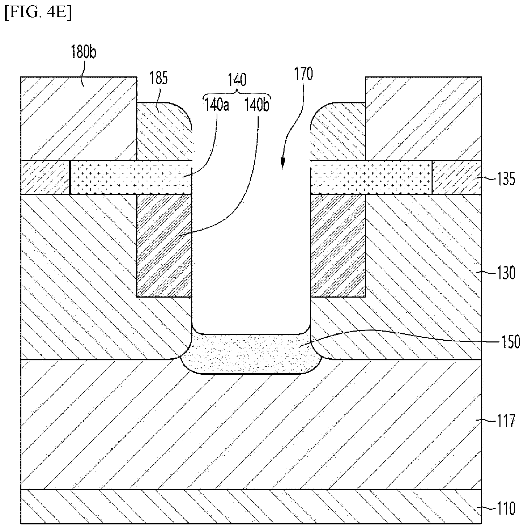

Next, referring to FIG. 4E, a JFET region (150) can be formed through an implant process at the lower portion of the trench (170), but is not limited thereto. The JFET region (150) can be disposed between a plurality of wells of the second conductivity type (130). In addition, the bottom surface of the JFET region (150) may be positioned lower than the bottom surface of the wells of the second conductivity type (130).

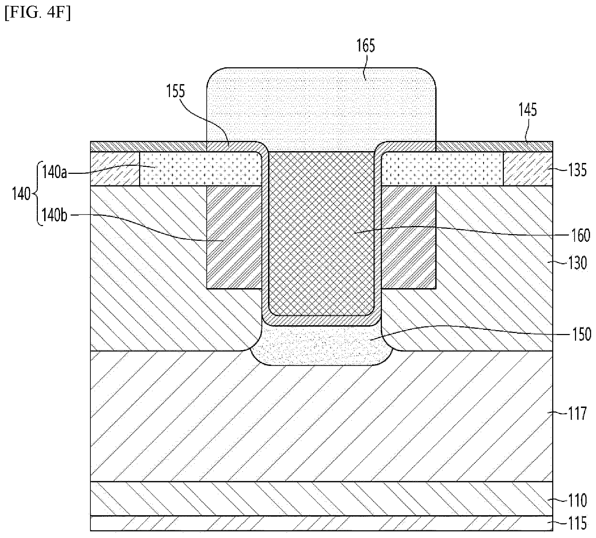

Next, referring to FIG. 4F, a gate insulating layer (155) may be formed on the trench. The gate insulating layer (155) may be a thermal oxide film or a deposition oxide film, but is not limited thereto. In addition, a gate (160) may be formed on an inner side of the gate insulating layer (155). The top surface of the gate (160) may be formed to correspond to the top surface of the first doped region of the first conductivity type (140a). In addition, the bottom surface of the gate (160) may be positioned lower than the bottom surface of the second doped region of the first conductivity type (140b). In addition, an edge area of the lower side of the gate insulating layer (155) may be in contact with the wells of the second conductivity type (130). Accordingly, the embodiment has a technical effect of forming the wells of the second conductivity type (130) so as to be in contact with the lower edge region of the trench gate, thereby preventing the electric field concentration in the lower edge region of the trench gate.

In addition, a source contact layer (145) may be formed on the ion implantation region of the second conductivity type (135) of the second conductive type, and a source electrode (not shown) may be formed on the source contact layer (145) in a subsequent process.

Next, an insulating layer (165) may be formed on the gate (160) and the gate insulating layer (155). The insulating layer (165) may be formed of an oxide film or a nitride film, but is not limited thereto.

In addition, a source electrode (not shown) may be formed on the source contact layer (145). The source electrode may be formed to cover the insulating layer (165). The source electrode may be formed of Al or Al alloy, but is not limited thereto. In addition, the source electrode may further include a barrier metal layer.

In addition, a drain electrode (115) may be formed on the lower side of the substrate (110). The drain electrode (115) may include, but is not limited to, Ti/Ni/Ag metal including a Ti layer, a Ni layer, and an Ag layer, or NiV/Ag, V(vanadium)/Ni/Ag, etc.

The power semiconductor device according to the embodiment has a technical effect of preventing the electric field concentration in the lower edge area of the trench gate.

For example, in the embodiment, the electric field concentration in the lower edge area of the trench gate can be prevented by arranging the wells of the second conductivity type to be in contact with the lower edge area of the trench gate.

In addition, the embodiment can prevent the electric field concentration in the lower edge region of the trench gate without the P-Shield formation process, so that a high-energy ion implantation process is not required, thereby preventing damage to the device and simplifying the process.

In addition, the embodiment has a technical effect that can improve the reliability of the device during high-speed switching.

For example, since the doping concentration of the second doped region of the first conductivity type disposed on the side of the trench gate is formed lower than the doping concentration of the first doped region of the first conductivity type, the saturation current decreases and the SCWT (Short Circuit Withstand Time) increases, so that the reliability of the device during high-speed switching can be improved.

Although the above has been described with reference to the embodiments of the present invention, those skilled in the art will easily understand that the present invention can be variously modified and changed within the scope that does not depart from the spirit and scope of the present invention described in the following patent claims.

### [Reference numbers]

| | | | |
|---|---|---|---|
| 110: | substrate | 115: | drain electrode |
| 117: | epi layer of the first conductivity type | 130: | wells of the second conductivity type |
| 135: | ion implantation region of the second conductivity type | 140: | doped region of the first conductivity type |
| 140a: | first doped region of the first conductivity type | 140b: | second doped region of the first conductivity type |
| 145: | source contact layer | 150: | JFET region |
| 155: | gate insulating layer | 160: | gate |
| 165: | insulating layer | 170: | trench |
| 180a: | first mask | 185: | spacer |

## Claims

1. A power semiconductor device comprising:
a substrate;
an epi layer of a first conductivity type disposed on the substrate;
a plurality of wells of a second conductivity type spaced apart from each other on the epi layer of the first conductivity type; and
a gate disposed between the plurality of wells of the second conductivity type and a gate insulating layer disposed to surround at least a portion of the gate; and
a doped region of the first conductivity type disposed on a side of the gate insulating layer,
wherein the doped region of the first conductivity type comprises a first doped region of the first conductivity type and a second doped region of the first conductivity type disposed below the first doped region of the first conductivity type, and
wherein a doping concentration of the second doped region of the first conductivity type is lower than a doping concentration of the first doped region of the first conductivity type.

2. The power semiconductor device according to claim 1, wherein a bottom surface of the second doped region of the first conductivity type is positioned higher than a bottom surface of the gate.

3. The power semiconductor device according to any one of claims 1 to 2, wherein a lower edge region of the gate insulating layer is in contact with the wells of the second conductivity type.

4. The power semiconductor device according to any one of claims 1 to 3, wherein a bottom surface of the wells of the second conductivity type is positioned lower than a bottom surface of the gate insulating layer.

5. The power semiconductor device according to any one of claims 1 to 4, wherein the doped region of the first conductivity type and the epi layer of the first conductivity type are spaced apart from each other, and
wherein the wells of the second conductivity type are positioned between the doped region of the first conductivity type and the epi layer of the first conductivity type.

6. The power semiconductor device according to any one of claims 1 to 5, wherein the first doped region of the first conductivity type and the second doped region of the first conductivity type are in contact with one side surface of the gate insulating layer.

7. The power semiconductor device according to any one of claims 1 to 6, wherein a thickness of the first doped region of the first conductivity type in a depth direction is less than that of the second doped region of the first conductivity type in the depth direction.

8. The power semiconductor device according to any one of claims 1 to 7, wherein a width of the second doped region of the first conductivity type in a horizontal direction is less than that of the first doped region of the first conductivity type in the horizontal direction.

9. The power semiconductor device according to any one of claims 1 to 8, wherein a depth of the doped region of the first conductivity type is shallower than the depth of the gate.

10. The power semiconductor device according to any one of claims 1 to 9, wherein the second doped region of the first conductivity type is not vertically overlapped with the source contact layer.

11. The power semiconductor device according to any one of claims 1 to 10, further comprising a JFET region disposed on a bottom surface of the gate insulating layer, and
wherein the JFET region is in contact with the wells of the second conductivity

12. The power semiconductor device according to any one of claims 1 to 11, wherein an upper surface of the second doped region of the first conductivity type is in contact with a bottom surface of the first doped region of the first conductivity type.

13. The power semiconductor device according to any one of claims 1 to 12, wherein an inner surface of the second doped region of the first conductivity type is aligned vertically with an inner surface of the first doped region of the first conductivity type.

14. The power semiconductor device according to any one of claims 1 to 13, wherein a vertical thickness of the second doped region of the first conductivity type is greater than 1/2 of a vertical thickness of the gate.

15. A power converter including the power semiconductor device according to any one of claims 1 to 14.
